# EUROPEAN PATENT APPLICATION

(11) **EP 4 543 162 A1**
(43) Date of publication of application: **23.04.2025**
(21) Application number: 24168134.5
(22) Date of filing: 02.04.2024
(51) Int. Cl.: H10B 12/00, H01L 21/762

(54) **SEMICONDUCTOR MEMORY DEVICE**

(30) Priority: 16.10.2023 KR 20230137974
(71) Applicant: Samsung Electronics Co., Ltd., Suwon-si, Gyeonggi-do 16677 (KR)
(72) Inventor: BAE, Byeongjun, 16677 Suwon-si (KR); SON, Youngwoo, 16677 Suwon-si (KR)
(74) Representative: Marks & Clerk LLP

(57) **Abstract**

Provided is a semiconductor memory device. The semiconductor memory device includes a plurality of trenches including a plurality of first trenches in a substrate and a plurality of second trenches between ones of the plurality of first trenches, and a plurality of device isolation layers. A first height of a lowermost surface of a direct contact in a vertical direction may be higher than a second height of a lowermost surface of a buried contact in the vertical direction, relative to a lower surface of the substrate.

## Description

### BACKGROUND OF THE INVENTION

The inventive concepts relate to a semiconductor memory device.

With the rapid development of the electronics industry and user demands, electronic devices have become smaller and lighter. Accordingly, semiconductor devices having a high degree of integration are needed for use in electronic devices, and thus, the design rules for components of a semiconductor device have decreased (e.g. become more restrictive). As a result, the complexity of a manufacturing process for ensuring the connection reliability between the conductive patterns constituting a semiconductor device has gradually increased.

As the degree of integration of semiconductor devices has gradually increased, a semiconductor device structure having a buried cell array transistor (BCAT), which has a structure in which a plurality of word lines are buried in a substrate, has been proposed.

### SUMMARY OF THE INVENTION

The inventive concepts provide a semiconductor memory device having improved reliability in control of a gate electrode.

According to aspects of the inventive concepts, there is provided a semiconductor memory device including a plurality of trenches comprising a plurality of first trenches in a substrate and a plurality of second trenches between ones of the plurality of first trenches, a plurality of device isolation layers comprising first device isolation layers and second device isolation layers in the plurality of first trenches, respectively, and third device isolation layers in the plurality of second trenches, respectively, a plurality of active regions defined by the plurality of device isolation layers, a word line on the plurality of active regions, a plurality of direct contacts that electrically connect the word line to the plurality of active regions, a plurality of buried contacts between ones of the plurality of direct contacts, and a plurality of fins between ones of the plurality of direct and buried contacts, wherein respective widths of the plurality of first trenches in a first direction and a second direction are greater than respective widths of the plurality of second trenches in the first direction and the second direction, wherein the first and second directions are parallel to a lower surface of the substrate, and wherein the second direction is perpendicular to the first direction, wherein respective depths of the plurality of first trenches in a vertical direction are greater than respective depths of the plurality of second trenches in the vertical direction, wherein the vertical direction is perpendicular to the lower surface of the substrate, and wherein the vertical direction is perpendicular to the first and second directions, and wherein respective first heights of lowermost surfaces of the plurality of direct contacts in the vertical direction are higher than respective second heights of lowermost surfaces of the plurality of buried contacts in the vertical direction, relative to the lower surface of the substrate.

According to aspects of the inventive concepts, there is provided a semiconductor memory device including a plurality of trenches comprising a plurality of first trenches in a substrate and a plurality of second trenches between ones of the plurality of first trenches, a plurality of device isolation layers comprising first device isolation layers and second device isolation layers in the plurality of first trenches, respectively, and third device isolation layers in the plurality of second trenches, respectively, a plurality of active regions defined by the plurality of device isolation layers, a word line on the plurality of active regions, a plurality of direct contacts that electrically connect the word line to the plurality of active regions, and a plurality of buried contacts between ones of the plurality of direct contacts, wherein, in a plan view: the plurality of active regions extend diagonally with respect to a first direction and a second direction perpendicular to the first direction, ones of the plurality of active regions include longitudinal sides opposing each other and transverse sides opposing each other, and at least portions of the longitudinal sides respectively include protrusions that protrude outwardly in a direction in which the transverse sides extend.

According to aspects of the inventive concepts, there is provided a semiconductor memory device including a plurality of trenches comprising a plurality of first trenches in a substrate and a plurality of second trenches between ones of the plurality of first trenches, a plurality of device isolation layers comprising first device isolation layers and second device isolation layers in the plurality of first trenches, respectively, and third device isolation layers in the plurality of second trenches, respectively, a plurality of active regions defined by the plurality of device isolation layers, a word line on the plurality of active regions, a plurality of direct contacts that electrically connect the word line to the plurality of active regions, a plurality of buried contacts between ones of the plurality of direct contacts, a plurality of fins between ones of the plurality of direct and buried contacts, and a word line lower layer on a lowermost surface of the word line and between the word line and the plurality of fins, wherein respective widths of the plurality of first trenches in a first direction and a second direction are greater than respective widths of the plurality of second trenches in the first direction and the second direction, wherein the first and second directions are parallel to a lower surface of the substrate, and wherein the second direction is perpendicular to the first direction, wherein respective depths of the plurality of first trenches in a vertical direction are greater than respective depths of the plurality of second trenches in the vertical direction, wherein the vertical direction is perpendicular to the lower surface of the substrate, and wherein the vertical direction is perpendicular to the first and second directions, wherein, when a minimum interval between adjacent wires included in the semiconductor memory device is F: a minimum interval between central axes of an adjacent pair of the plurality of fins in the first direction is greater than 2F and less than 4F, intervals between central axes of adjacent ones of the plurality of fins in the first direction are different from each other, at least one of the plurality of fins extends in the vertical direction from a first point equal to 1/2 of a sum of a first height of a lowermost surface of one of the plurality of direct contacts and a second height of a lowermost surface of one of the plurality of buried contacts to a second point equal to an uppermost surface of the substrate, the first and second heights being taken in the vertical direction relative to the lower surface of the substrate, at least portions of outer surfaces of the plurality of fins have round shapes, respectively, and upper surfaces of the plurality of fins in the vertical direction comprise vertices of the round shapes, respectively, the word line lower layer comprises an insulating material, at least a portion of the word line lower layer has a round shape surrounding the plurality of fins, at least another portion of the word line lower layer has a flat shape in the first direction and the second direction, first portions of the word line lower layer are on the plurality of fins, respectively, second portions of the word line lower layer are on the first device isolation layers, respectively, and third portions of the word line lower layer are on the third device isolation layers, respectively, respective third heights of the first portions of the word line lower layer in the vertical direction are equal to each other, relative to the lower surface of the substrate, respective fourth heights of the second portions of the word line lower layer in the vertical direction are different from respective fifth heights of the third portions of the word line lower layer in the vertical direction, relative to the lower surface of the substrate, respective widths of the second portions of the word line lower layer in the first direction and the second direction are equal to the respective widths of the plurality of first trenches in the first direction and the second direction, respective widths of the third portions of the word line lower layer in the first direction and the second direction are equal to the respective widths of the plurality of second trenches in the first direction and the second direction, the second portions of the word line lower layer are in contact with the plurality of first trenches, respectively, and the third portions of the word line lower layer are in contact with the plurality of second trenches, respectively, the plurality of device isolation layers have a tapered shape such that respective widths of the plurality of device isolation layers in each of the first direction and the second direction become narrower with increasing distance toward the lower surface of the substrate in the vertical direction, the plurality of device isolation layers comprise silicon oxide, silicon nitride, or a combination thereof, at least one of the first device isolation layers and at least one of the second device isolation layers comprise different materials from each other, the second device isolation layers are inside the first device isolation layers, respectively, and the first height of the lowermost surface of the one of the plurality of direct contacts is higher than the second height of the lowermost surface of the one of the plurality of buried contacts, relative to the lower surface of the substrate.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIGS. 1A, 1B, 2A, 2B, 3A, 3B, 4A, 4B, 5A, and 5B are diagrams illustrating sequential processes of a method of manufacturing a semiconductor memory device, according to some embodiments;
FIG. 6A is a layout diagram illustrating main components of a semiconductor memory device according to some embodiments;
FIG. 6B is a cross-sectional view illustrating a semiconductor memory device according to some embodiments;
FIG. 7 is a block diagram illustrating an example configuration of a semiconductor device according to some embodiments;
FIG. 8 is a plan view illustrating an arrangement configuration of a semiconductor memory device according to some embodiments;
FIG. 9 is a block diagram illustrating a system including a semiconductor memory device, according to some embodiments; and
FIG. 10 is a block diagram illustrating a memory card including a semiconductor memory device, according to some embodiments.

### DETAILED DESCRIPTION

Embodiments set forth herein may have various modifications and various forms, and thus, some embodiments will be illustrated in the drawings and described in detail. However, this is not intended to limit the embodiments to specific disclosed forms. Also, the embodiments described below are merely illustrative, and various modifications may be made from these embodiments.

The use of all examples or illustrative terms is merely for describing the inventive concepts in detail, and thus, the scope of the inventive concepts is not limited by these examples or illustrative terms unless limited by the claims.

Hereinafter, unless specified otherwise, a horizontal direction is described as a first direction X and a second direction Y that is perpendicular to the first direction X, and a vertical direction is described as a vertical direction Z that is perpendicular to the first and second directions X and Y. It will be understood that these (and other) directions are example directions expressed relative to a given device, and do not imply any particular orientation of that device.

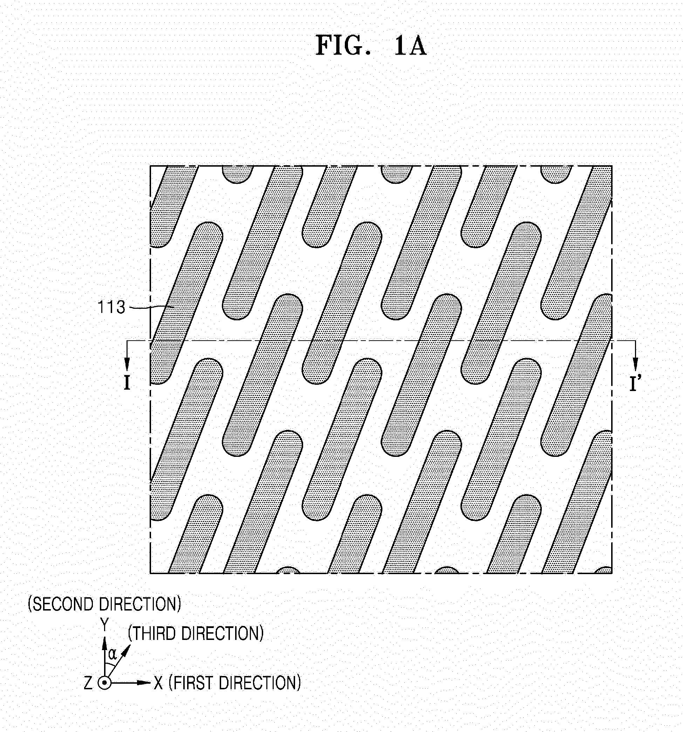

FIGS. 1A, 1B, 2A, 2B, 3A, 3B, 4A, 4B, 5A, and 5B are diagrams illustrating sequential processes of a method of manufacturing a semiconductor memory device, according to some embodiments.

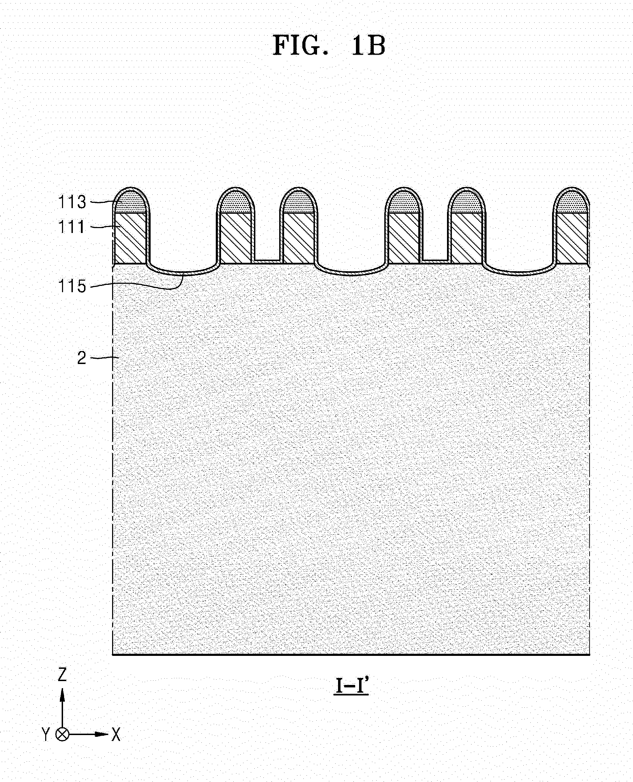

In particular, FIGS. 1A, 2A, 3A, 4A, and 5A are plan views illustrating sequential processes of a method of manufacturing of an integrated circuit device. FIGS. 1B, 2B, 3B, 4B, and 5B are cross-sectional views taken along positions corresponding to line I-I' of FIGS. 1A, 2A, 3A, 4A, and 5A, respectively.

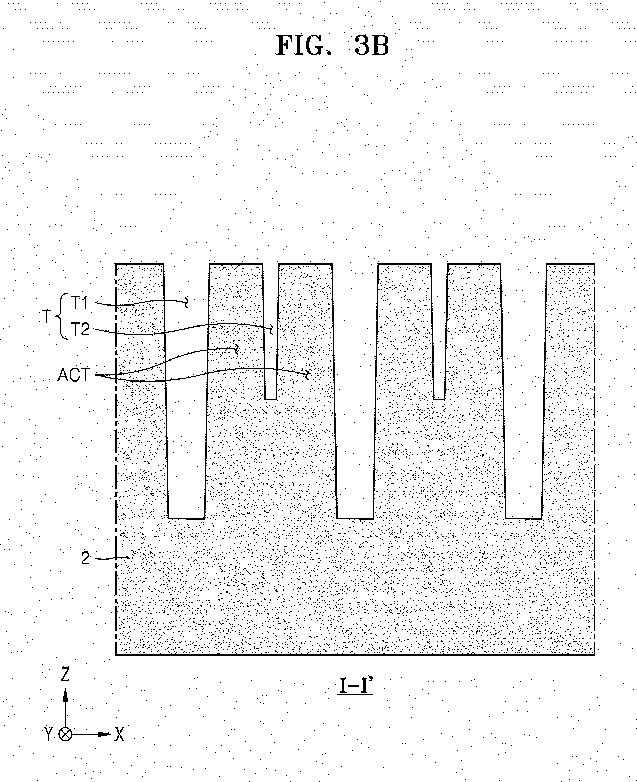

Referring to FIGS. 1A and 1B, on a substrate 2, a first member 111 and a second member 113 may be formed through a photolithography process, and a trench T (see FIG. 3B) may be formed. A first layer 115 may be formed in a region where the trench T (see FIG. 3B) is to be formed. The first layer 115 may be formed to surround side and/or upper surfaces of the first member 111 and the second member 113, as well as the region where the trench T (see FIG. 3B) is to be formed in the substrate 2. It will be understood that "an element A surrounds an element B" (or similar language) as used herein means that the element A is at least partially around the element B but does not necessarily mean that the element A completely encloses the element B. The first member 111 may be attached (i.e., connected) to an upper surface of the substrate 2, and the second member 113 may be attached (i.e., connected) to an upper surface of the first member 111 in the vertical direction Z. As used herein, "an element A connected to an element B" (or similar language) means that the element A is physically and/or electrically connected to the element B. The first member 111 and the second member 113 may include a plurality of bar shapes extending diagonally with respect to the first direction X and the second direction Y. In other words, the first member 111 and the second member 113 may extend in a third direction having a certain inclination α (i.e., a certain angle α) with respect to the second direction Y. The certain inclination α may be formed in a range of about 20 degrees to about 40 degrees, but is not limited thereto. For example, the first and second directions X and Y may be parallel to a lower surface of the substrate 2, and the vertical direction Z may be perpendicular to the lower surface of the substrate 2.

The first member 111 and the second member 113 may include an insulating material, and the first member 111 and the second member 113 may include different materials. For example, the first member 111 and the second member 113 may include SiN, SiO, SiON, SiOC, metal oxide, or a combination thereof.

The first layer 115, which is on (e.g., covers) at least portions of the upper surfaces of the first member 111, the second member 113, and the substrate 2, may protect the substrate 2 from external foreign substances or the like. Also, the first layer 115 may function as an etching stop layer in an etching process for a different type of material layer in a subsequent process. The trench T (see FIG. 3B) may be formed in the substrate 2 to penetrate (i.e., extend into) the first layer 115.

In some embodiments, the substrate 2 may be a semiconductor wafer. In some embodiments, the substrate 2 may include silicon (Si). In some other embodiments, the substrate 2 may include a semiconductor element such as germanium (Ge), or a compound semiconductor such as silicon carbide (SiC), gallium arsenide (GaAs), indium arsenide (InAs), and indium phosphide (InP). In some embodiments, the substrate 2 may have a silicon on insulator (SOI) structure. For example, the substrate 2 may include a buried oxide (BOX) layer. In some embodiments, the substrate 2 may include a conductive region, for example, an impurity-doped well or an impurity-doped structure. Also, the substrate 2 may have various device isolation structures such as a shallow trench isolation (STI) structure.

A plurality of individual devices of various types may be formed on the substrate 2. The plurality of individual devices may include various microelectronic devices, for example, a metal-oxide-semiconductor field effect transistor (MOSFET), a system large scale integration (LSI), an image sensor such as a complementary metal-oxide semiconductor (CMOS) imaging sensor (CIS), a micro-electro-mechanical system (MEMS), an active element, a passive element, and the like.

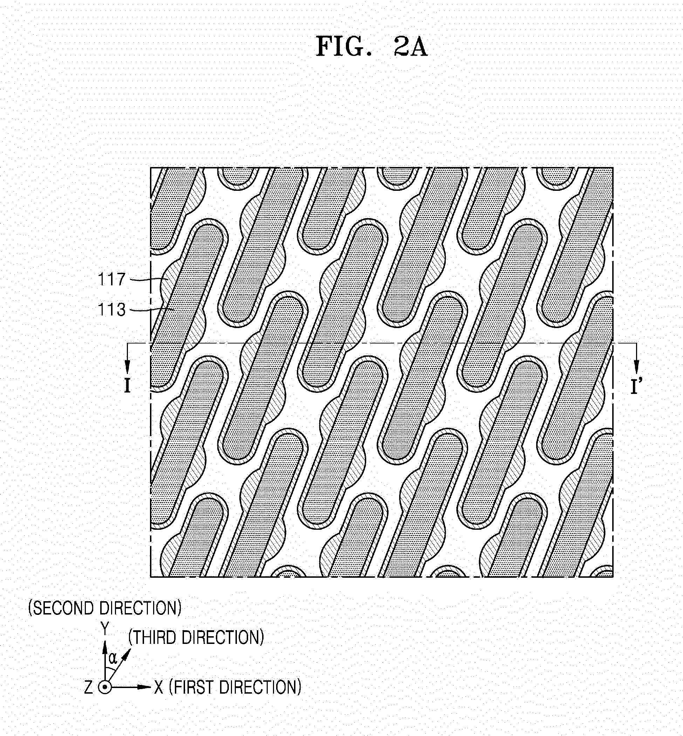

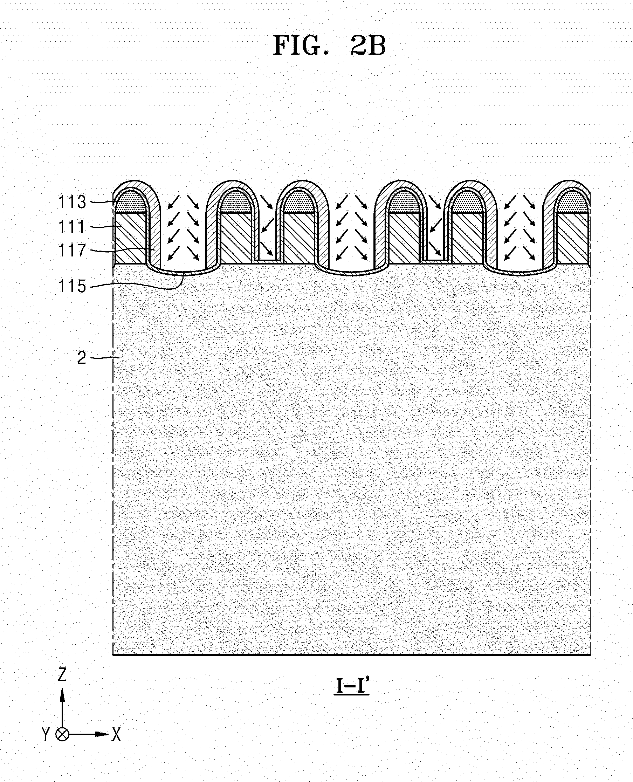

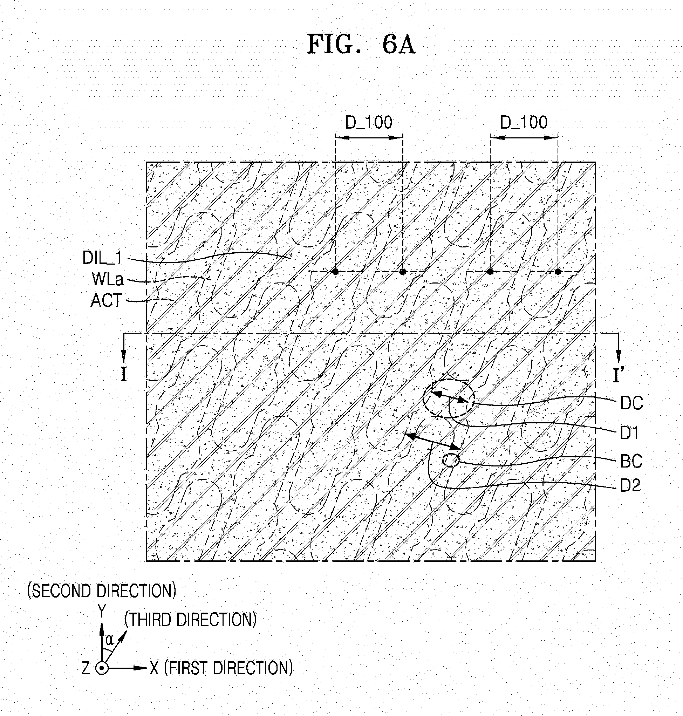

Referring to FIGS. 2A and 2B, a second layer 117 may be formed to surround at least portions of the first member 111 and the second member 113. The second layer 117 may not be formed in the region where the trench T (see FIG. 3B) is to be formed in the substrate 2. In a portion of the second layer 117 that is to become an active region ACT (see FIG. 6A), a difference in loading may occur such that the second layer 117 has different widths between major axes and between minor axes. In a plan view of the active region ACT (see FIG. 6A), a direct contact DC (see FIG. 6A) may be formed in a region between major axes, and a buried contact BC (see FIG. 6A) may be formed in a region between minor axes. In other words, as shown in the plan view of FIG. 2A, the second layer 117 may be formed to be wider in a region of the substrate 2 where the direct contact DC (see FIG. 6A), which is wide, is to be formed between major axes than in a region of the substrate 2 where the buried contact BC (see FIG. 6A), which is narrow, is to be formed between minor axes. By forming the second layer 117 to have different widths (e.g., in the first direction X in FIG. 2B), the direct contact DC (see FIG. 6A) may be formed to be relatively narrow.

By forming the second layer 117 to have different widths depending on a region of the substrate 2, the trench T (see FIG. 3B) may be formed to have different widths and depths. In other words, due to differences in the widths of the second layer 117, an amount of gas used for etching may be adjusted differently. The amount of gas is as indicated by arrows in FIG. 2B. Due to differences in the amount of gas introduced into each region, the trench T (see FIG. 3B) may be formed to have a different widths and depth for each region. The gas used in the etching process may be formed by mixing chlorine (Cl₂) and oxygen (O₂). As a result, widths of a plurality of first trenches T1 (see FIG. 3B) in the first direction X and the second direction Y, which is perpendicular to the first direction X, may be greater than widths of a plurality of second trenches T2 (see FIG. 3B) in the first direction X and the second direction Y, and lengths (i.e., depths) of the plurality of first trenches T1 (see FIG. 3B) in the vertical direction Z, which is perpendicular to the first direction X and the second direction Y, may be greater than lengths (i.e., depths) of the plurality of second trenches T2 (see FIG. 3B) in the vertical direction Z.

After forming the second layer 117 to be uniform just before etching, an additional layer may be deposited by sputtering, which facilitates formation of the second layer 117, so that the direct contact DC (see FIG. 6A) in a wide region and the buried contact BC (see FIG. 6A) in a relatively narrow region have different widths, and thus, the trench T (see FIG. 3B), in which the direct contact DC (see FIG. 6A) and the buried contact BC (see FIG. 6A) are to be formed, may be formed to have different widths and depths. Referring to FIG. 2A, planar shapes of the first member 111, the second member 113, and the second layer 117 may correspond to a planar shape of the active region ACT (see FIG. 6A).

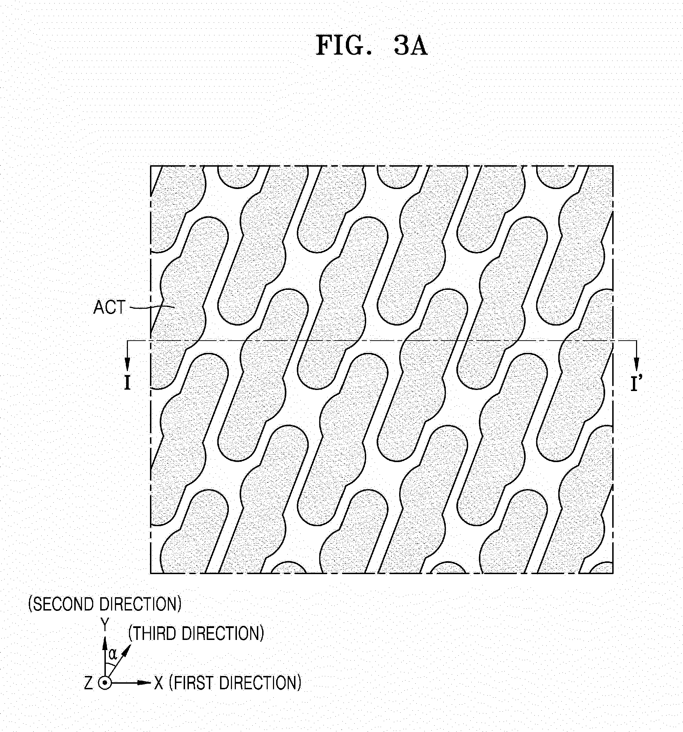

Referring to FIGS. 3A and 3B, the semiconductor memory device may include a plurality of trenches T provided in the substrate 2.

The plurality of trenches T may include a plurality of first trenches T1 provided in the substrate 2 and a plurality of second trenches T2 provided between ones of the plurality of first trenches T1. The first trench T1 and the second trench T2 may have different widths and depths from each other. Due to the nature of a dry etching process, the widths of the first trench T1 and the second trench T2 may become narrower toward the lower portions thereof. Accordingly, sidewalls of the first trench T1 and the second trench T2 may not be vertical, and may have a tapered shape having a slight inclination. The first trench T1 may be formed to be deeper than the second trench T2, and the first trench T1 may be formed to be wider than the second trench T2. The plurality of trenches T may be formed to isolate devices.

Referring to FIG. 3A, in a plan view, the active region ACT may be formed to have a relatively long island shape having a minor axis and a major axis, and at least a portion of the major axis of the active region ACT may have a protrusion that protrudes further in a direction of the minor axis. For example, in a plan view, the major axis of each active region ACT may be taken in the third direction, and the minor axis of each active region ACT may be taken in a horizontal direction that is perpendicular to the third direction. That is, the major axis of each active region ACT corresponds to the longest diameter of each active region ACT (e.g., in the third direction), and the minor axis of each active region ACT corresponds to the shortest diameter of each active region ACT (e.g., in a horizontal direction perpendicular to the third direction). As used herein, a "major axis direction" refers to a direction taken along the major axis of the active regions ACT, and a "minor axis direction" refers to a direction taken along the minor axis of the active regions ACT. One protrusion may be formed for each major axis of the active region ACT (i.e., for each side of the active region ACT that extends in the major axis direction), and the protrusions may be located apart from each other and may be formed in facing (i.e., opposing) directions. A distance between the protrusions and a distance between the major axes will be described in detail with reference to FIG. 6A. The protrusion may be formed to have a shape substantially the same as that of the second layer 117 (see FIG. 2A) in a plan view.

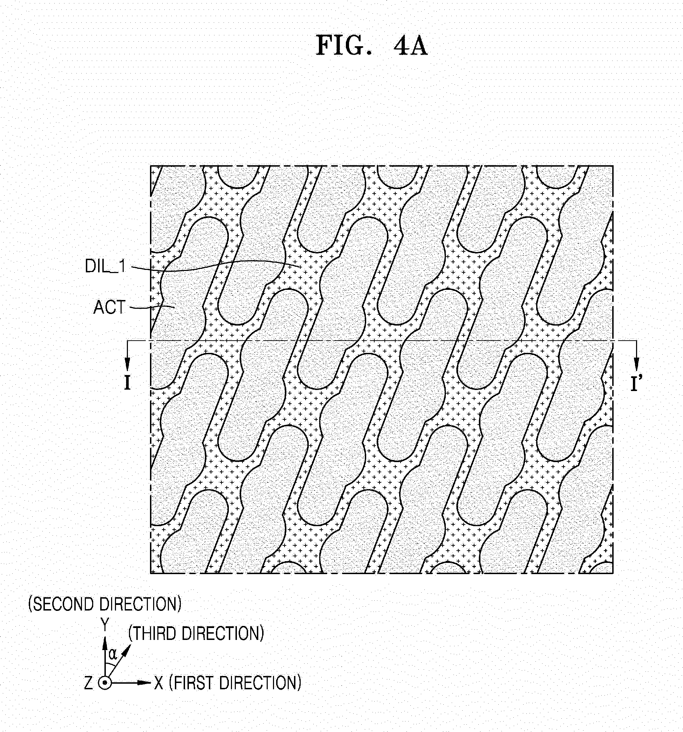

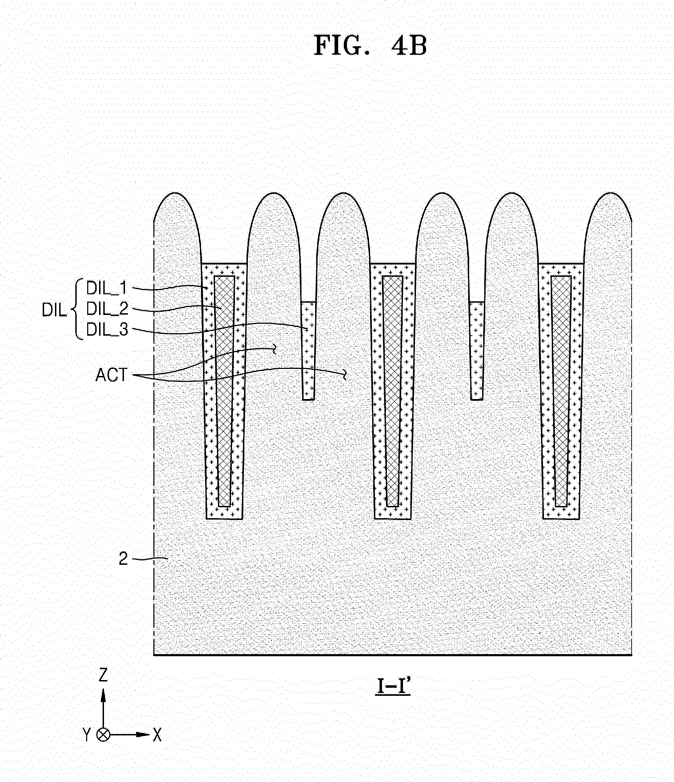

Referring to FIGS. 4A and 4B, the plurality of trenches T may be filled with an insulating material to form a plurality of device isolation layers DIL.

The device isolation layer DIL may include a first device isolation layer DIL_1, a second device isolation layer DIL_2, and a third device isolation layer DIL_3. Although the first device isolation layer DIL_1, the second device isolation layer DIL_2, and the third device isolation layer DIL_3 are shown as being formed simultaneously, the third device isolation layer DIL_3 may be formed sequentially after the first device isolation layer DIL_1 and the second device isolation layer DIL_2 are formed. In some other embodiments, the first device isolation layer DIL_1 and the second device isolation layer DIL_2 may be formed sequentially after the third device isolation layer DIL_3 is formed. The second device isolation layer DIL_2 may be formed in the first device isolation layer DIL_1. For example, the second device isolation layer DIL_2 may be inside the first device isolation layer DIL_1.

The plurality of device isolation layers DIL may have different structures depending on a horizontal width of the trench T (see FIG. 3B). For example, the device isolation layer DIL may have a first structure including a single insulating layer, such as the third device isolation layer DIL_3. Also, the device isolation layer DIL may have a second structure including the first device isolation layer DIL_1 and the second device isolation layer DIL_2 (i.e., a multi-layer structure). The first device isolation layer DIL_1 and the second device isolation layer DIL_2 may be provided in the first trench T1 (see FIG. 3B). The third device isolation layer DIL_3 may be provided in the second trench T2 (see FIG. 3B). The first device isolation layer DIL_1 and the second device isolation layer DIL 2 may include different materials from each other. For example, the first device isolation layer DIL_1 may include an oxide layer, and the second device isolation layer DIL_2 may include a nitride layer. However, a configuration of the device isolation layer DIL is not limited thereto. For example, as described above, the device isolation layer DIL may include a single layer including one type of insulating layer, such as the third device isolation layer DIL_3, and/or a multi-layer including a combination of at least two types of insulating layers.

The plurality of device isolation layers DIL may be formed to have a tapered shape in which a width in each of the first direction X and the second direction Y becomes narrower toward a lower portion thereof in the vertical direction Z. For example, respective widths of the plurality of device isolation layers DIL in each of the first direction X and the second direction Y may become narrower with increasing distance toward a lower surface of the substrate 2 in the vertical direction Z.

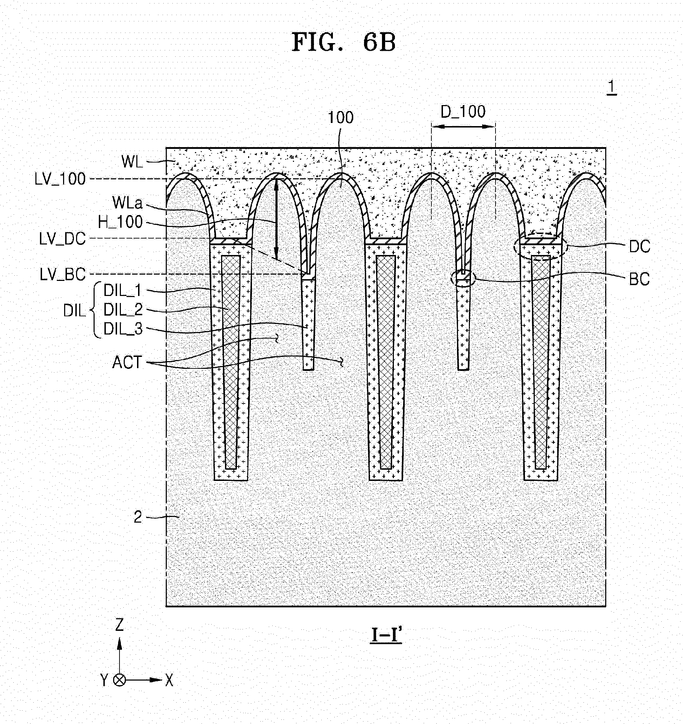

Here, an uppermost surface of the device isolation layer DIL may be formed at a level substantially the same as that of an uppermost surface of the substrate 2, and may then be etched to a level lower than that of the uppermost surface of the substrate 2. As used herein, the term "level" indicates a height in the vertical direction Z from a lower surface of the substrate 2. In other words, "a level" (or similar language) as used herein refers to a height taken in the vertical direction Z, relative to the lower surface of the substrate 2. It will be understood that a "level" as used herein may also be referred to as a "height". A level of an upper surface of the first device isolation layer DIL_1 after etching may be formed to be higher than a level of an upper surface of the third device isolation layer DIL_3. In detail, a width of the first trench T1 (see FIG. 3B), in which the first device isolation layer DIL_1 and the second device isolation layer DIL_2 are provided, may be formed to be greater than a width of the second trench T2 (see FIG. 3B), in which the third device isolation layer DIL_3 is provided. By supplying similar amounts of etching gas to the upper surfaces of the first device isolation layer DIL_1 and the third device isolation layer DIL_3, an etching amount per unit area of the third device isolation layer DIL_3 may be greater than that of the first device isolation layer DIL_1. Accordingly, an uppermost surface of the third device isolation layer DIL_3 may be formed to be lower than an uppermost surface of the first device isolation layer DIL_1. By forming the uppermost surface of the third device isolation layer DIL_3 to be lower than the uppermost surface of the first device isolation layer DIL_1, a buried contact level LV_BC (see FIG. 6B) may be formed to be lower than a direct contact level LV_DC (see FIG. 6B). This will be described in greater detail with reference to FIG. 6B. Although the uppermost surfaces of the first device isolation layer DIL_1 and the third device isolation layer DIL_3 are shown to have a flat shape with each formed at a uniform height in the vertical direction Z, the first device isolation layer DIL_1 and the third device isolation layer DIL_3 are not limited thereto, and the heights of their uppermost surfaces may not be formed to be uniform due to the nature of a dry etching process.

A plurality of active regions ACT may be defined on the substrate 2 by the device isolation layer DIL. Referring to the cross-sectional view of the active region ACT, a plurality of fins 100 (see FIG. 6B) may be formed in upper portions of the active regions ACT, and in the process of etching the substrate 2, at least portions of outer circumferential surfaces of the plurality of fins 100 (see FIG. 6B) may be formed to have a round shape.

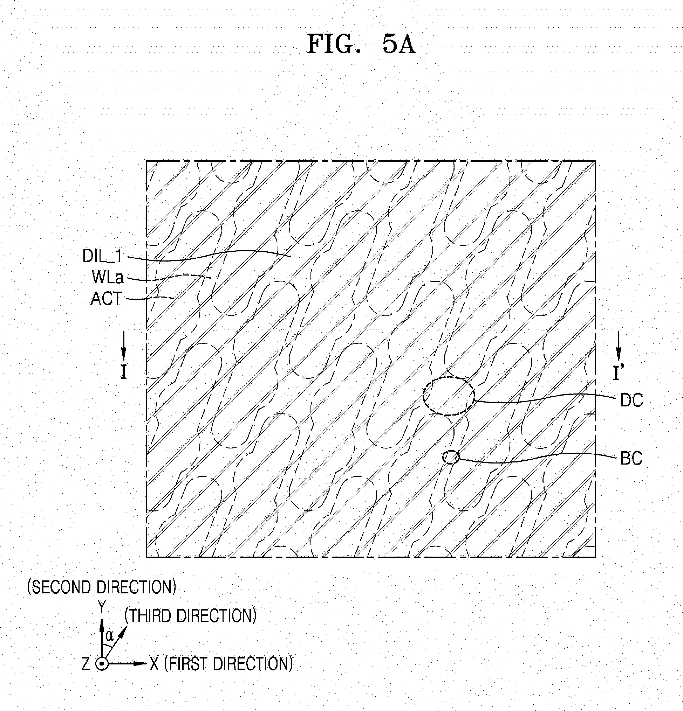

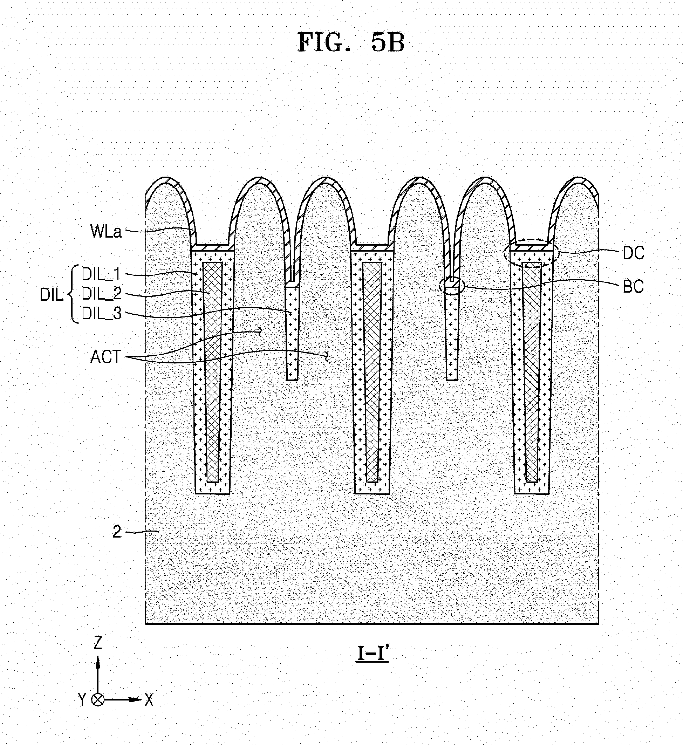

Referring to FIGS. 5A and 5B, a word line lower layer WLa may be formed to surround upper surfaces of the plurality of device isolation layers DIL and at least a portion of an upper surface of the active region ACT formed on the substrate 2. The word line lower layer WLa may be on (e.g., may cover) inner walls of the first trench T1 (see FIG. 3B) and the second trench T2 (see FIG. 3B). The word line lower layer WLa may be formed to have a thickness of about 200 Å to about 400 Å. The word line lower layer WLa may include silicon oxide. For example, the word line lower layer WLa may include tetraethylorthosilicate (TEOS), high density plasma (HDP), or boro-phospho silicate glass (BPSG).

The word line lower layer WLa may include an insulating material, at least a portion of the word line lower layer WLa may have a round shape surrounding the fin 100 (see FIG. 6B), and at least a portion of the word line lower layer WLa may have a flat shape in the first direction X and the second direction Y (e.g., on the first device isolation layer DIL_1 and/or the third device isolation layer DIL_3). Levels of an uppermost surface of the word line lower layer WLa may be formed to be the same as each other, but levels of a lower surface of the word line lower layer WLa may be formed to be different from each other. For example, first portions of the word line lower layer WLa may be on the plurality of fins 100 (see FIG. 6B), respectively, second portions of the word line lower layer WLa may be on the first device isolation layers DIL_1, respectively, and third portions of the word line lower layer WLa may be on the third device isolation layers DIL_3, respectively. Respective heights (e.g., a level LV_100 in FIG. 6B) of the first portions of the word line lower layer WLa in the vertical direction Z may be equal to each other, relative to a lower surface of the substrate 2. Respective heights (e.g., the level LV_DC in FIG. 6B) of the second portions of the word line lower layer WLa in the vertical direction Z may be different from respective heights (e.g., the level LV_BC in FIG. 6B) of the third portions of the word line lower layer WLa in the vertical direction Z, relative to the lower surface of the substrate 2. Also, a width of the lower surface of the word line lower layer WLa in the first direction X and the second direction Y may be formed to be the same as a width of the trench T (see FIG. 3B), which is in contact with the lower surface of the word line lower layer WLa, in the first direction X and the second direction Y. For example, respective widths of the second portions of the word line lower layer WLa in the first direction X and the second direction Y may be equal to respective widths of the plurality of first trenches T1 (see FIG. 3B) in the first direction X and the second direction Y, and respective widths of the third portions of the word line lower layer WLa in the first direction X and the second direction Y may be equal to respective widths of the plurality of second trenches T2 (see FIG. 3B) in the first direction X and the second direction Y. The second portions of the word line lower layer WLa may be in contact with the plurality of first trenches T1 (see FIG. 3B), respectively, and the third portions of the word line lower layer WLa may be in contact with the plurality of second trenches T2 (see FIG. 3B), respectively.

FIG. 6A is a layout diagram illustrating main components of a semiconductor memory device 1 according to some embodiments. FIG. 6B is a cross-sectional view illustrating the semiconductor memory device 1 according to some embodiments. In particular, FIG. 6B is a cross-sectional view taken along a position corresponding to line I-I' of FIG. 6A.

Referring to FIGS. 6A and 6B, the semiconductor memory device 1 may be a dynamic random-access memory (DRAM) device. The semiconductor memory device 1 may include a plurality of unit devices (i.e., a plurality of unit cells or memory cells) arranged in an array. Here, each unit device may have a 1T1C structure including one transistor and one capacitor.

The semiconductor memory device 1 may include a plurality of trenches T (see FIG. 3B) including a plurality of first trenches T1 (see FIG. 3B) provided in the substrate 2 and a plurality of second trenches T2 (see FIG. 3B) provided between ones of the plurality of first trenches T1 (see FIG. 3B), a plurality of device isolation layers DIL including first device isolation layers DIL_1 and second device isolation layers DIL_2 provided in the plurality of first trenches T1 (see FIG. 3B) and third device isolation layers DIL_3 provided in the plurality of second trenches T2 (see FIG. 3B), a plurality of active regions ACT defined by the plurality of device isolation layers DIL, a word line WL formed on one side of the plurality of active regions ACT in the vertical direction Z, a plurality of direct contacts DC electrically connecting the word line WL to the plurality of active regions ACT, a plurality of buried contacts BC located between ones of the plurality of direct contacts DC, and a plurality of fins 100 located between ones of the plurality of direct and buried contacts DC and BC. For example, a respective one of the fins 100 may be between a respective one of the direct contacts DC and a respective one of the buried contacts BC.

A level LV_DC of a lowermost surface of a formation region of the direct contact DC may be formed to be higher than a level LV_BC of a lowermost surface of a formation region of the buried contact BC, and thus, the region of the buried contact BC may be formed to be deeper than the region of the direct contact DC. As a result, a distance between the fins 100 may be widened, and thus, when a minimum interval between adjacent wires is F (feature size), an inter-fin distance D_100 of greater than 2F and less than 4F may be formed. For example, the inter-fin distance D_100 may be a minimum interval (i.e., a minimum distance) between central axes of an adjacent pair of the fins 100 in the first direction X. That is, the inter-fin distance D_100 may be a minimum center-to-center distance between an adjacent pair of the fins 100 in the first direction X. For example, the central axis of each fin 100 refers to an imaginary line that goes through the center of each fin 100. Also, because the widths of ones of the plurality of trenches T (see FIG. 3B) in the first direction X and the second direction Y are different from each other, intervals between central axes of the plurality of fins 100 in the first direction X may be different from each other. That is, because the widths of the first trenches T1 (see FIG. 3B) are different from the widths of the second trenches T2 (see FIG. 3B) in the first direction X and the second direction Y, intervals between central axes of the plurality of fins 100 in the first direction X may be different from each other. For example, the interval between central axes of adjacent ones of the fins 100 in the first direction X with the second trench T2 (see FIG. 3B) therebetween may be shorter than the interval between central axes of adjacent ones of the fins 100 in the first direction X with the first trench T1 (see FIG. 3B) therebetween. In other words, intervals between central axes of adjacent ones of the fins 100 in the first direction X may be different from each other. As used herein, "F" refers to the feature size of the semiconductor memory device 1. The feature size may refer to a minimum distance between components within the semiconductor memory device 1 and thus may be described as a minimum interval (i.e., a minimum distance) between adjacent wires included in the semiconductor memory device 1. Feature size is typically measured in nanometers (nm) and may be used to represent the smallest element in a unit device (i.e., a unit cell or memory cell) of the semiconductor memory device 1.

The plurality of fins 100 may be formed from a point equal to 1/2 of the sum of the level LV_DC of the lowermost surface of the direct contact DC and the level LV_BC of the lowermost surface of the buried contact BC to a level LV_100 of an uppermost surface of the substrate 2, at least portions of outer circumferential surfaces of the plurality of fins 100 may have a round shape, and peak points of the plurality of fins 100 in the vertical direction Z may be formed as vertices of the round shapes. For example, the plurality of fins 100 may extend from a first point to a second point in the vertical direction Z. The first point may be equal to 1/2 of the sum of the level LV_DC (i.e., the height LV_DC) of the lowermost surface of the direct contact DC in the vertical direction Z and the level LV_BC (i.e., the height LV_BC) of the lowermost surface of the buried contact BC in the vertical direction Z. The second point may be equal to an uppermost surface of the substrate 2 in the vertical direction Z (i.e., may be equal to the level LV_100). For example, at least portions of outer surfaces of the plurality of fins 100 may have round shapes, respectively, and upper surfaces of the plurality of fins 100 in the vertical direction Z may include vertices of the round shapes, respectively. As used herein, the term "vertices" refers to respective points on the round shapes at which the round shapes make their maximum turn (e.g., a turning point). In other words, the vertex of each round shape may be a point where the round shape has its tightest bend. For example, as shown in FIG. 6B, each of the fins 100 includes an upper surface having a round shape, and each round shape has a vertex at which it makes its maximum turn. For example, the vertex of each round shape may correspond to a center point of the upper surface of each fin 100.

As the buried contact BC is formed to be relatively deep, a margin for filling a metal near the buried contact BC may be increased, and as a fin height H_100 is increased, control of a gate may be facilitated, and thus, characteristics of the gate may be improved, and defects of the gate may be reduced. Although omitted in the drawings, a channel layer may be formed. In some embodiments, the channel layer may include a semiconductor material. For example, the channel layer may include single crystal silicon or polysilicon. In some other embodiments, the channel layer may include an oxide semiconductor material. The channel layer may include at least one of a binary or ternary oxide semiconductor material including a first metal element, a ternary oxide semiconductor material including a first metal element and a second metal element that are different from each other, and a quaternary oxide semiconductor material including a first metal element, a second metal element, and a third metal element that are different from each other. The binary or ternary oxide semiconductor material may be one of, for example, ZnO (zinc oxide, ZnxO), GaO (gallium oxide, GaxO), SnO (tin oxide, SnxO), ZnON (zinc oxynitride, ZnxOyN), IZO (indium zinc oxide, InxZnyO), GZO (gallium zinc oxide, GaxZnyO), TZO (tin zinc oxide, SnxZnyO), or TGO (tin gallium oxide, SnxGayO), but is not limited thereto. The quaternary oxide semiconductor material may be one of, for example, IGZO (indium gallium zinc oxide, InxGaYZnzO), IGSO (indium gallium silicon oxide, InxGaySizO), ITZO (indium tin zinc oxide, InxSnYZnzO), IGTO (indium gallium tin oxide, InxGaySnzO), ZZTO (zirconium zinc tin oxide, ZrXZnySnzO), HIZO (hafnium indium zinc oxide, HfxInYZnzO), GZTO (gallium zinc tin oxide, GaXZnySnzO), AZTO (aluminium zinc tin oxide, AlXZnySnzO), YGZO (ytterbium gallium zinc oxide, YbxGaYZnzO), or IAZO (indium aluminum zinc oxide), but is not limited thereto. In some embodiments, the channel layer may include a crystalline oxide semiconductor material or an amorphous oxide semiconductor material. When the channel layer includes a crystalline oxide semiconductor material, the channel layer may have crystallinity of at least one of single crystalline, polycrystalline, spinel, or c-axis aligned crystalline (CAAC). In some embodiments, the channel layer may be formed by stacking at least two layers including a first layer including a crystalline oxide semiconductor material and a second layer including an amorphous oxide semiconductor material. For example, the channel layer may be formed by sequentially stacking a first layer including a crystalline oxide semiconductor material, a second layer including an amorphous oxide semiconductor material, and a third layer including a crystalline oxide semiconductor material.

The word line WL may be formed on an upper surface of the word line lower layer WLa in the vertical direction Z. For example, the word line lower layer WLa may be on a lowermost surface of the word line WL and between the word line WL and the plurality of fins 100. The word line WL may include a conductive material. For example, the word line WL may include at least one of a metal, a semiconductor, or an alloy. The metal may include, for example, aluminum (Al), tungsten (W), molybdenum (Mo), titanium (Ti), tantalum (Ta), or the like. The semiconductor may include, for example, a group IV semiconductor material, a group III-V semiconductor material, an oxide semiconductor, a nitride semiconductor, an oxynitride semiconductor, or the like. However, embodiments are not limited thereto. A plurality of word lines WL may be formed to have the same length in the vertical direction Z. In some other embodiments, lengths of the plurality of word lines WL in the vertical direction Z may be different from each other, but are not limited thereto. In some embodiments, after the word line WL is formed, source/drain regions may be formed on upper surfaces of the plurality of active regions ACT by implanting impurity ions into the substrate 2 from opposite sides of the word line WL. In some other embodiments, an impurity ion implantation process for forming source/drain regions may be performed before the plurality of word lines WL are formed. Although the word line WL is shown as a single layer, the word line WL may include a first word line layer and a second word line layer arranged on an upper surface of the first word line layer in the vertical direction Z, and the first word line layer and the second word line layer may include different materials from each other and are not limited to the shape, thickness, or the like shown in the drawings.

Also, although not shown in the drawings, in some embodiments, the semiconductor memory device 1 may include a plurality of bit lines arranged apart from the word line WL. Each of the plurality of bit line may include polysilicon, metal, conductive metal nitride, conductive metal silicide, conductive metal oxide, or a combination thereof. For example, the bit line may include doped polysilicon, Al, Cu, Ti, Ta, Ru, W, Mo, Pt, Ni, Co, TiN, TaN, WN, WSi, NbN, TiAl, TiAlN, TiSi, TiSiN, TaSi, TaSiN, RuTiN, NiSi, CoSi, IrOx, RuOx, or a combination thereof, but is not limited thereto. In some other embodiments, the bit line may include a two-dimensional semiconductor material. The two-dimensional semiconductor material may include, for example, graphene, carbon nanotubes, or a combination thereof. The bit line may include a single layer or a multi-layer including the above-described conductive materials.

Also, although not shown in the drawings, in some embodiments, the semiconductor memory device 1 may include a gate electrode arranged apart from the word line WL. The gate electrode may include a first conductive pattern, a second conductive pattern arranged on a lower surface of the first conductive pattern, and a third conductive pattern arranged on a lower surface of the second conductive pattern. The first conductive pattern, the second conductive pattern, and the third conductive pattern may include different materials from each other, and thicknesses of the respective patterns may be different from each other. Also, a gate dielectric layer surrounding the gate electrode may be formed. The gate dielectric layer may include at least one of a silicon oxide layer, a silicon nitride layer, a silicon oxynitride layer, an oxide/nitride/oxide (ONO) layer, or a high-k dielectric layer having a dielectric constant higher than that of silicon oxide. For example, the gate dielectric layer may have a dielectric constant of about 10 to about 25. In some embodiments, the gate dielectric layer may include at least one of hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), strontium titanium oxide (SrTiO), yttrium oxide (YO), aluminum oxide (AlO), or lead scandium tantalum oxide (PbScTaO). For example, the gate dielectric layer may include HfO₂, Al₂O₃, HfAlO₃, Ta₂O₃, or TiO₂.

Also, although not shown in the drawings, a landing pad may be formed in the semiconductor memory device 1. In detail, the landing pad may be formed by sequentially forming a conductive barrier layer and a conductive layer. A plurality of conductive landing pads connected to the plurality of buried contacts BC may be formed in spaces between each pair of conductive lines including a plurality of bit lines in a cell array region. A method of forming the landing pad may be performed through chemical vapor deposition (CVD), but is not limited thereto. Also, in the process of forming the landing pad, the conductive layer may be formed on an upper surface of a direct contact plug in a core/peripheral region. Each conductive barrier layer may have a Ti/TiN stack structure. The conductive layer may include doped polysilicon, metal, metal silicide, conductive metal nitride, or a combination thereof.

In a plan view, as shown in FIG. 6A, the plurality of active regions ACT may extend diagonally with respect to the first direction X and the second direction Y perpendicular to the first direction X, to be formed to have an island shape. That is, the plurality of active regions ACT may extend in the third direction to have an island shape. The active regions ACT may have longitudinal sides and transverse sides intersecting (i.e., connected to) each other, the longitudinal sides may face (i.e., oppose) each other, and the transverse sides may face (i.e., oppose) each other. For example, the longitudinal sides may extend perpendicular to the transverse sides. The longitudinal sides are the longer sides of each active region ACT in the plan view and extend in the third direction. The transverse sides are the shorter sides of each active region ACT in the plan view and extend in a horizontal direction perpendicular to the third direction. At least portions of the longitudinal sides of the active regions ACT may respectively have protrusions protruding in a direction in which the transverse sides extend. In other words, at least a portion of each of the longitudinal sides may include a protrusion that protrudes outwardly in a direction in which the transverse sides extend. A formation position of the direct contact DC may be a formation position of an isolation layer between the active regions ACT in a major axis direction, and a formation position of the buried contact BC may be a formation position of an isolation layer between the active regions ACT in a minor axis direction. That is, each direct contact DC may be between ones of the active regions ACT in a major axis direction (i.e., the third direction), and each buried contact BC may be between ones of the active regions ACT in a minor axis direction (i.e., a horizontal direction perpendicular to the third direction). The isolation layer between ones of the active regions ACT in the major axis direction may be the first device isolation layer DIL_1. Although not shown in FIG. 6A, the isolation layer between ones of the active regions ACT in the minor axis direction may be the third device isolation layer DIL_3 (see DIL_3 in FIG. 6B). One of the protrusions may be formed on each of the longitudinal sides of the active region ACT that face (i.e., oppose) each other, and the protrusions may protrude toward the formation position of the direct contact DC. In the plan view, a pair of the active regions ACT adjacent to each other in the minor axis direction with the direct contact DC therebetween may be referred to as a first active region and a second active region. The first active region may have a first longitudinal side and a first transverse side, and the second active region may have a second longitudinal side and a second transverse side. A first protrusion may be formed on the first longitudinal side, a second protrusion may be formed on the second longitudinal side, and the direct contact DC may be formed between the first and second protrusions. A first distance D1, which is a shortest (i.e., minimum) distance between the first protrusion and the second protrusion, may be less than a second distance D2, which is a distance between the first longitudinal side and the second longitudinal side on respective portions thereof where the protrusions are not present. The protrusions may not be formed on an identical axis on the longitudinal sides of the active regions ACT that face (i.e., oppose) each other, and each of the plurality of active regions ACT may be formed to have an asymmetric shape with respect to a major axis of the active region ACT as a central axis. That is, the protrusions on respective longitudinal sides of each active region ACT may be spaced apart from each in the major axis direction (i.e., the third direction), and thus, in the plan view, each of the plurality of active regions ACT may have an asymmetric shape. For example, the respective longitudinal sides of each active region ACT may be asymmetrical with each other along the major axis direction. In other words, the protrusions on respective longitudinal sides of each active region ACT may be offset from each other (i.e., may not be directly across from each other) in the minor axis direction (i.e., a horizontal direction perpendicular to the third direction). As used herein, "element A and element B are offset from each other in the X direction" (or similar language) means that the element A and the element B are not aligned with each other along the X direction. Also, the transverse sides of the active regions ACT and the protrusions may be formed to have a round shape, but are not limited thereto.

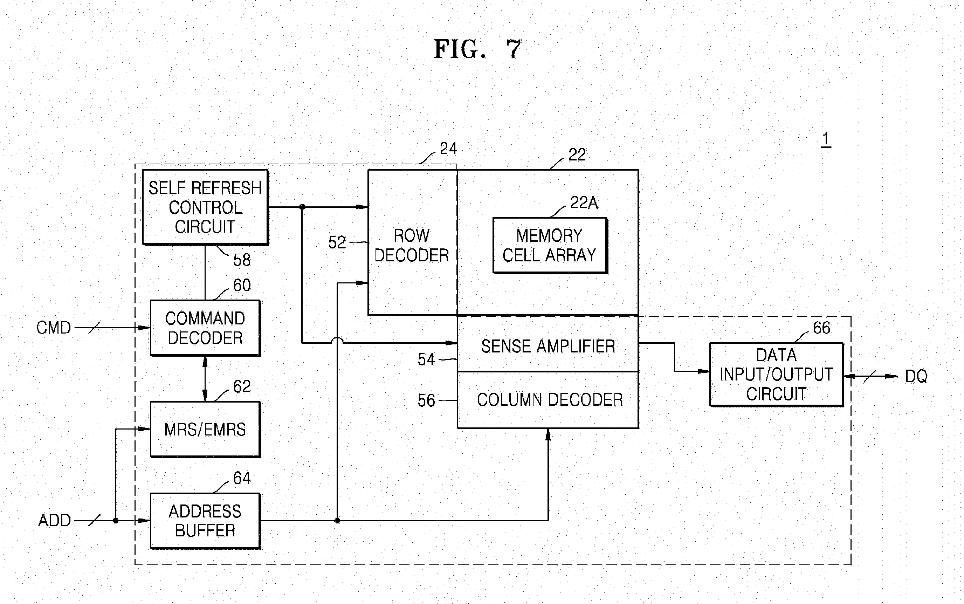

FIG. 7 is a block diagram illustrating an example configuration of the semiconductor memory device 1 according to some embodiments.

Referring to FIG. 7, the semiconductor memory device 1 may include a first region 22 and a second region 24. The first region 22 may be a memory cell region of a DRAM device, and the second region 24 may be a peripheral circuit region of the DRAM device. The first region 22 may include a memory cell array 22A. The second region 24 may include a row decoder 52, a sense amplifier 54, a column decoder 56, a self refresh control circuit 58, a command decoder 60, a mode register set/extended mode register set (MRS/EMRS) circuit 62, an address buffer 64, and a data input/output circuit 66.

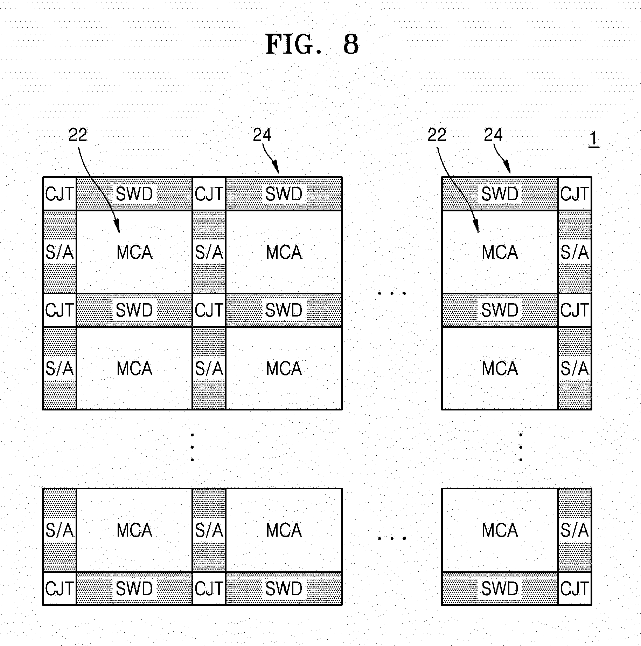

FIG. 8 is a plan view illustrating an arrangement configuration of the semiconductor memory device 1 according to some embodiments.

Referring to FIG. 8, the semiconductor memory device 1 may include a plurality of first regions 22. Each of the plurality of first regions 22 may be surrounded by the second region 24.

Each of the plurality of first regions 22 may be a cell array region MCA of a DRAM device, and the second region 24 may be a region where peripheral circuits of the DRAM device are formed and may include a core region.

The second region 24 may include a sub-word line driver block SWD, a sense amplifier block S/A, and a conjunction block CJT. A plurality of bit line sense amplifiers may be arranged in the sense amplifier block S/A. The conjunction block CJT may be arranged at a point where the sub-word line driver block SWD intersects with the sense amplifier block S/A. Power drivers and ground drivers for driving the bit line sense amplifiers may be alternately arranged in the conjunction block CJT. Peripheral circuits, such as an inverter chain and an input/output circuit, may be further formed in the second region 24.

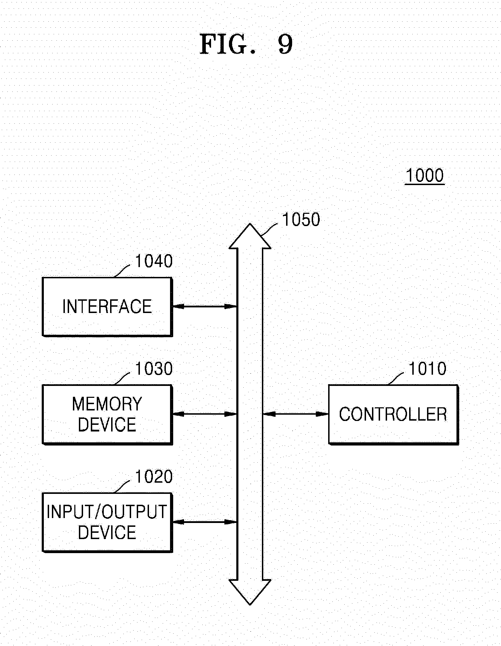

FIG. 9 is a block diagram illustrating a system 1000 including a semiconductor memory device, according to some embodiments.

Referring to FIG. 9, the system 1000 may include a controller 1010, an input/output device 1020, a memory device 1030, and an interface 1040. The system 1000 may be a mobile system or a system for transmitting or receiving information. In some embodiments, the mobile system may be a personal digital assistant (PDA), a portable computer, a web tablet, a wireless phone, a mobile phone, a digital music player, or a memory card. The controller 1010 may control execution programs in the system 1000, and may include a microprocessor, a digital signal processor, a microcontroller, or a device similar thereto. The input/output device 1020 may be used to input or output data of the system 1000. The system 1000 may be connected to an external device, for example, a personal computer or a network, by using the input/output device 1020, and may exchange data with the external device. The input/output device 1020 may be, for example, a keypad, a keyboard, or a display.

The memory device 1030 may store code and/or data for operations of the controller 1010, or may store data processed by the controller 1010. The memory device 1030 may include a semiconductor device. For example, the memory device 1030 may include the semiconductor memory device 1 described above with reference to FIGS. 1 to 8.

The interface 1040 may be a data transmission path between the system 1000 and other external devices. The controller 1010, the input/output device 1020, the memory device 1030, and the interface 1040 may communicate with each other via a bus 1050. The system 1000 may be used in a mobile phone, an MP3 player, a navigation device, a portable multimedia player (PMP), a solid state disk (SSD), and/or household appliances.

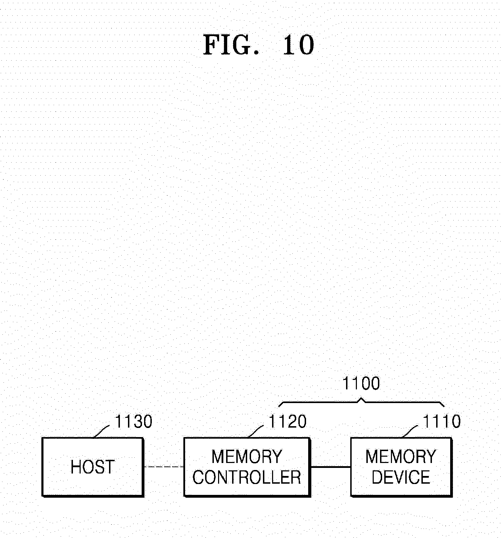

FIG. 10 is a block diagram illustrating a memory card 1100 including a semiconductor memory device, according to some embodiments.

Referring to FIG. 10, the memory card 1100 may include a memory device 1110 and a memory controller 1120.

The memory device 1110 may store data. In some embodiments, the memory device 1110 may have non-volatile characteristics that allow stored data to be retained even when a power supply is interrupted. The memory device 1110 may include a semiconductor device. For example, the memory device 1110 may include the semiconductor memory device 1 described above with reference to FIGS. 1 to 8.

The memory controller 1120 may read data stored in the memory device 1110, or may store data of the memory device 1110 in response to a read/write request from a host 1130. The memory controller 1120 may include a semiconductor device. For example, the memory controller 1120 may include the semiconductor memory device 1 described above with reference to FIGS. 1 to 8.

As used herein, it will be understood that the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof.

While the inventive concepts have been particularly shown and described with reference to example embodiments thereof, it will be understood that various changes in form and details may be made therein without departing from the scope of the following claims.

## Claims

1. A semiconductor memory device comprising:
a plurality of trenches comprising a plurality of first trenches in a substrate and a plurality of second trenches between ones of the plurality of first trenches;
a plurality of device isolation layers comprising first device isolation layers and second device isolation layers in the plurality of first trenches, respectively, and third device isolation layers in the plurality of second trenches, respectively;
a plurality of active regions defined by the plurality of device isolation layers;
a word line on the plurality of active regions;
a plurality of direct contacts that electrically connect the word line to the plurality of active regions;
a plurality of buried contacts between ones of the plurality of direct contacts; and
a plurality of fins between ones of the plurality of direct and buried contacts,
wherein respective widths of the plurality of first trenches in a first direction and a second direction are greater than respective widths of the plurality of second trenches in the first direction and the second direction, wherein the first and second directions are parallel to a lower surface of the substrate, and wherein the second direction is perpendicular to the first direction,
wherein respective depths of the plurality of first trenches in a vertical direction are greater than respective depths of the plurality of second trenches in the vertical direction, wherein the vertical direction is perpendicular to the lower surface of the substrate, and wherein the vertical direction is perpendicular to the first and second directions, and
wherein respective first heights of lowermost surfaces of the plurality of direct contacts in the vertical direction are higher than respective second heights of lowermost surfaces of the plurality of buried contacts in the vertical direction, relative to the lower surface of the substrate.

2. The semiconductor memory device of claim 1, wherein, when a minimum interval between adjacent wires included in the semiconductor memory device is F, a minimum interval between central axes of an adjacent pair of the plurality of fins in the first direction is greater than 2F and less than 4F.

3. The semiconductor memory device of claim 2, wherein intervals between central axes of adjacent ones of the plurality of fins in the first direction are different from each other.

4. The semiconductor memory device of any preceding claim, wherein at least one of the plurality of fins extends in the vertical direction from a first point equal to 1/2 of a sum of one of the first heights and one of the second heights to a second point equal to an uppermost surface of the substrate, and
wherein at least portions of outer surfaces of the plurality of fins have round shapes, respectively, and upper surfaces of the plurality of fins in the vertical direction comprise vertices of the round shapes, respectively.

5. The semiconductor memory device of any preceding claim, further comprising a word line lower layer on a lowermost surface of the word line and between the word line and the plurality of fins.

6. The semiconductor memory device of claim 5, wherein the word line lower layer comprises an insulating material,
wherein at least a first portion of the word line lower layer has a round shape surrounding the plurality of fins, and
wherein at least a second portion of the word line lower layer has a flat shape in the first direction and the second direction.

7. The semiconductor memory device of claim 5 or claim 6, wherein first portions of the word line lower layer are on the plurality of fins, respectively, second portions of the word line lower layer are on the first device isolation layers, respectively, and third portions of the word line lower layer are on the third device isolation layers, respectively,
wherein respective third heights of the first portions of the word line lower layer in the vertical direction are equal to each other, relative to the lower surface of the substrate, and
wherein respective fourth heights of the second portions of the word line lower layer in the vertical direction are different from respective fifth heights of the third portions of the word line lower layer in the vertical direction, relative to the lower surface of the substrate.

8. The semiconductor memory device of claim 7, wherein respective widths of the second portions of the word line lower layer in the first direction and the second direction are equal to the respective widths of the plurality of first trenches in the first direction and the second direction,
wherein respective widths of the third portions of the word line lower layer in the first direction and the second direction are equal to the respective widths of the plurality of second trenches in the first direction and the second direction, and
wherein the second portions of the word line lower layer are in contact with the plurality of first trenches, respectively, and the third portions of the word line lower layer are in contact with the plurality of second trenches, respectively.

9. The semiconductor memory device of any preceding claim, wherein the plurality of device isolation layers have a tapered shape such that respective widths of the plurality of device isolation layers in each of the first direction and the second direction become narrower with increasing distance toward the lower surface of the substrate in the vertical direction.

10. A semiconductor memory device comprising:
a plurality of trenches comprising a plurality of first trenches in a substrate and a plurality of second trenches between ones of the plurality of first trenches;
a plurality of device isolation layers comprising first device isolation layers and second device isolation layers in the plurality of first trenches, respectively, and third device isolation layers in the plurality of second trenches, respectively;
a plurality of active regions defined by the plurality of device isolation layers;
a word line on the plurality of active regions;
a plurality of direct contacts that electrically connect the word line to the plurality of active regions; and
a plurality of buried contacts between ones of the plurality of direct contacts,
wherein, in a plan view:
the plurality of active regions extend diagonally with respect to a first direction and a second direction perpendicular to the first direction,
ones of the plurality of active regions include longitudinal sides opposing each other and transverse sides opposing each other, and
at least portions of the longitudinal sides respectively include protrusions that protrude outwardly in a direction in which the transverse sides extend.

11. The semiconductor memory device of claim 10, wherein, in the plan view:
the plurality of direct contacts are between ones of the plurality of active regions in a major axis direction of the plurality of active regions, and
the plurality of buried contacts are between ones of the plurality of active regions in a minor axis direction of the plurality of active regions.

12. The semiconductor memory device of claim 11, wherein, in the plan view:
the first device isolation layers are between the ones of the plurality of active regions in the major axis direction, and
the third device isolation layers are between the ones of the plurality of active regions in the minor axis direction.

13. The semiconductor memory device of any of claims 10 to 12, wherein, in the plan view, a first active region and a second active region of the plurality of active regions are adjacent to each other, and
wherein, in the plan view:
the first active region includes a first one of the longitudinal sides and a first one of the transverse sides,
the second active region includes a second one of the longitudinal sides and a second one of the transverse sides,
the first one of the longitudinal sides includes a first one of the protrusions,
the second one of the longitudinal sides includes a second one of the protrusions, and
a shortest distance between the first one of the protrusions and the second one of the protrusions is less than a distance between respective portions of the first one of the longitudinal sides and the second one of the longitudinal sides where the protrusions are not present.

14. A semiconductor memory device comprising:
a plurality of trenches comprising a plurality of first trenches in a substrate and a plurality of second trenches between ones of the plurality of first trenches;
a plurality of device isolation layers comprising first device isolation layers and second device isolation layers in the plurality of first trenches, respectively, and third device isolation layers in the plurality of second trenches, respectively;
a plurality of active regions defined by the plurality of device isolation layers;
a word line on the plurality of active regions;
a plurality of direct contacts that electrically connect the word line to the plurality of active regions;
a plurality of buried contacts between ones of the plurality of direct contacts;
a plurality of fins between ones of the plurality of direct and buried contacts; and
a word line lower layer on a lowermost surface of the word line and between the word line and the plurality of fins,
wherein respective widths of the plurality of first trenches in a first direction and a second direction are greater than respective widths of the plurality of second trenches in the first direction and the second direction, wherein the first and second directions are parallel to a lower surface of the substrate, and wherein the second direction is perpendicular to the first direction,
wherein respective depths of the plurality of first trenches in a vertical direction are greater than respective depths of the plurality of second trenches in the vertical direction, wherein the vertical direction is perpendicular to the lower surface of the substrate, and wherein the vertical direction is perpendicular to the first and second directions,
wherein, when a minimum interval between adjacent wires included in the semiconductor memory device is F:
a minimum interval between central axes of an adjacent pair of the plurality of fins in the first direction is greater than 2F and less than 4F,
intervals between central axes of adjacent ones of the plurality of fins in the first direction are different from each other,
at least one of the plurality of fins extends in the vertical direction from a first point equal to 1/2 of a sum of a first height of a lowermost surface of one of the plurality of direct contacts and a second height of a lowermost surface of one of the plurality of buried contacts to a second point equal to an uppermost surface of the substrate, the first and second heights being taken in the vertical direction relative to the lower surface of the substrate,
at least portions of outer surfaces of the plurality of fins have round shapes, respectively, and upper surfaces of the plurality of fins in the vertical direction comprise vertices of the round shapes, respectively,
the word line lower layer comprises an insulating material,
at least a portion of the word line lower layer has a round shape surrounding the plurality of fins,
at least another portion of the word line lower layer has a flat shape in the first direction and the second direction,
first portions of the word line lower layer are on the plurality of fins, respectively, second portions of the word line lower layer are on the first device isolation layers, respectively, and third portions of the word line lower layer are on the third device isolation layers, respectively,
respective third heights of the first portions of the word line lower layer in the vertical direction are equal to each other, relative to the lower surface of the substrate,
respective fourth heights of the second portions of the word line lower layer in the vertical direction are different from respective fifth heights of the third portions of the word line lower layer in the vertical direction, relative to the lower surface of the substrate,
respective widths of the second portions of the word line lower layer in the first direction and the second direction are equal to the respective widths of the plurality of first trenches in the first direction and the second direction,
respective widths of the third portions of the word line lower layer in the first direction and the second direction are equal to the respective widths of the plurality of second trenches in the first direction and the second direction,
the second portions of the word line lower layer are in contact with the plurality of first trenches, respectively, and the third portions of the word line lower layer are in contact with the plurality of second trenches, respectively,
the plurality of device isolation layers have a tapered shape such that respective widths of the plurality of device isolation layers in each of the first direction and the second direction become narrower with increasing distance toward the lower surface of the substrate in the vertical direction,
the plurality of device isolation layers comprise silicon oxide, silicon nitride, or a combination thereof,
at least one of the first device isolation layers and at least one of the second device isolation layers comprise different materials from each other,
the second device isolation layers are inside the first device isolation layers, respectively, and
the first height of the lowermost surface of the one of the plurality of direct contacts is higher than the second height of the lowermost surface of the one of the plurality of buried contacts, relative to the lower surface of the substrate.

15. The semiconductor memory device of claim 14, wherein, in a plan view:
the plurality of active regions extend diagonally with respect to the first direction and the second direction,
ones of the plurality of active regions include longitudinal sides opposing each other and transverse sides opposing each other,
at least portions of the longitudinal sides respectively include protrusions that protrude outwardly in a direction in which the transverse sides extend,
the protrusions protrude toward ones of the plurality of direct contacts,
each of the longitudinal sides includes one of the protrusions,
the plurality of direct contacts are between ones of the plurality of active regions in a major axis direction of the plurality of active regions,
the plurality of buried contacts are between ones of the plurality of active regions in a minor axis direction of the plurality of active regions,
the first device isolation layers are between the ones of the plurality of active regions in the major axis direction,
the third device isolation layers are between the ones of the plurality of active regions in the minor axis direction,
each of the plurality of active regions has an asymmetric shape, and
the transverse sides and the protrusions have a round shape.
